# EUROPÄISCHE PATENTANMELDUNG

(11) **EP 1 321 446 A1**
(43) Veröffentlichungstag der Anmeldung: **25.06.2003**
(21) Anmeldenummer: 02003042.5
(22) Anmeldetag: 12.02.2002
(51) Int. Cl.: C04B 37/00, B32B 18/00, H01L 31/042

(54) **Verfahren zum Ausbilden einer Schichtstruktur auf einem Substrat**

(30) Priorität: 20.12.2001 DE 10163100
(71) Anmelder: RWE Solar GmbH, 63755 Alzenau (DE)
(72) Erfinder: Schwirtlich, Ingo, Physiker, 63897 Miltenberg (DE); Schmidt, Wilfried, Physiker, 74193 Schwaigern (DE); von Campe, Hilmar, Physiker, 61352 Bad Homburg (DE)
(74) Vertreter: Stoffregen, Hans-Herbert, Dr. Dipl.-Phys. Patentanwalt

(57) **Zusammenfassung**

Die Erfindung bezieht sich auf ein Verfahren zum Ausbilden einer Schichtstruktur auf einem insbesondere bruchempfindlichen flächigen Substrat. Damit dünne bruchempfindliche flächige Substrate im gewünschten Umfang Prozessen zur Veredelung oder zur Ausbildung von Halbleiterbauelementen unterzogen werden können, wird ein Verfahren mit den Schritten vorgeschlagen: Aufbringen einer anorganischen keramischen Masse auf das bruchempfindliche Substrat und anschließende Wärmebehandlung zum Aushärten und Sintern der anorganischen keramischen Masse.

## Beschreibung

Die Erfindung bezieht sich auf ein Verfahren zum Ausbilden einer Schichtstruktur auf einem insbesondere bruchempfindlichen flächigen Substrat. Ferner nimmt die Erfindung Bezug auf eine Solarzelle sowie auf die Verwendung einer anorganischen keramischen Masse.

Die Ausbildung von Schichtstrukturen sowohl bei makroskopischen als auch bei mikroskopischen Körpern ist hinlänglich bekannt. Als Beispiel sind Laminate in der Möbel- und Baustoffindustrie oder korrossionshemmende Beschichtungen von Metallen zu nennen.

Auch ist es bekannt, Beschichtungen zur Erhöhung der Oberflächenhärte auszubilden, um den Verschleiß von Bauteilen in Maschinen zu verringern.

In der Keramikindustrie werden Schichten zur Oberflächengestaltung auf Kacheln aufgebracht und eingebrannt.

Um Stahlbleche gegen chemische Einflüsse resistent und mechanische Angriffe beständig zu machen, können diese emailliert werden. Gleichzeitig ergibt sich eine ansprechend gestaltete Oberfläche.

Aus der Mikroelektronik sind Schichtaufbauten bekannt, bei denen die einzelnen Schichten photolithographisch strukturiert und epitaktisch über Gasphasen erzeugt werden. Durch übliche Epitaxieschichten werden in der Regel Funktionsbauelemente hergestellt. Als Substrate dienen dabei in der Regel polierte Halbleiterscheiben, die schichtweise aufgebaut werden.

Im Bereich der Solarzellenfertigung ist es bekannt, auf keramischen Substraten elektrisch aktive Schichten auf der Basis von Silicium oder vergleichbaren Halbleitern aufzubringen. Bei den insbesondere zur Anwendung gelangenden Verfahren handelt es sich um die Gasphasenepitaxie oder Flüssigphasenepitaxie, bei der z.B. schmelzflüssiges Silicium auf keramische Substrate aufgebracht wird.

Nach anderen Verfahren werden aus der Gasphase auf keramische Substrate aufgebrachte Schichten anschließend kristallisiert, um die elektrischen Eigenschaften zu verbessern. Im Bereich der Photovoltaik dienen diese Verfahren zur Einsparung teurer Halbleitermaterialien bzw. deren Ersatz durch preiswertere Keramik.

Die bisher bekannten Ansätze zur Dickenreduzierung von photoelektrischen Schichten gehen von einem tragenden Substrat aus, auf das über verschiedene Verfahren das halbleitende Material in Form einer oder mehrerer Schichten zur Bildung der Solarzelle aufgebaut werden.

Damit sich die Photovoltaik wirtschaftlich durchsetzen kann, ist die Reduzierung der Herstellungskosten von außerordentlicher Bedeutung. Im Vergleich zu mit konventionellen Mitteln erzeugter elektrischer Energie ist die über Solarzellen aus Sonnenlicht gewonnene immer noch zu teuer. Einen wesentlichen Anteil dazu tragen die Materialkosten bei.

Die Photovoltaik auf der Basis mono- oder multikristallinen Siliciums liefert sehr gute Energieumwandlungswirkungsgrade von Sonnenlicht in elektrischen Strom im Vergleich zu Solarzellen aus dünnen photoaktiven Schichten, die auf Substraten aufgebaut sind. Der Materialkostenanteil wird dabei in erster Linie durch den Preis der mono- oder multikristallinen Siliciumscheiben bestimmt. Daher ist es das Bestreben. möglichst dünne Scheibendicken zu erzielen, um die Kosten zu senken. Allerdings geht mit der Reduzierung der Schichtdicken die Erhöhung der Bruchraten bei der Prozessierung zur Solarzelle und später zum Modul einher. Je später in einem Produktionsablauf die Scheibe bricht, desto größer ist die verlorene Wertschöpfung.

Bei multikristallinen Siliciumscheiben werden die aus dem Gießen eines Blockes und anschließendem Zersägen Gewonnenen von denen unterschieden, die als Bänder oder in Form von Röhren - zum Beispiel nach dem EFG-Verfahren (Edge-defined Film-fed Growth) - direkt aus der Schmelze kristallisiert werden. Das Verhalten dieser Materialien ist jedoch unter mechanischen Belastungen unterschiedlich. Für die Weiterverarbeitung ist eine möglichst stabile Handhabung mit den gängigen Verfahren erforderlich, um eine hohe Wertschöpfung durch Reduzierung der Ausfälle zu erreichen. Dies gilt insbesondere für dünne Siliciumscheiben. Dies ist auch von Bedeutung, wenn Materialien unterschiedlicher Herstellung mit ein- und derselben Produktionslinie verarbeitet werden sollen.

Der vorliegenden Erfindung liegt das Problem zugrunde, ein Verfahren der eingangs genannten Art so weiterzubilden, dass dünne bruchempfindliche flächige Substrate im gewünschten Umfang Prozessen zur Veredelung oder zur Ausbildung von Halbleiterbauelementen wie Solarzellen unterzogen werden können, wobei auf kostengünstige Weise ein Schutz gegen Bruch und Verformung gegeben sein soll.

Erfindungsgemäß wird das Problem im Wesentlichen durch ein Verfahren zum Ausbilden einer Schichtstruktur auf einem insbesondere bruchempfindlichen flächigen Substrat durch die Verfahrensschritte gelöst:
- Aufbringen einer anorganischen keramischen Masse auf das bruchempfindliche Substrat und
- anschließende Wärmebehandlung zum Aushärten und Sintern der anorganischen keramischen Masse.

Erfindungsgemäß wird ein bruchempfindliches Substrat mit einer kostengünstigen anorganischen keramischen Masse höherer Festigkeit versehen, wodurch das Substrat die erforderliche Stabilität erfährt, so dass ein Schutz gegen Bruch und Verformung gegeben ist. Insbesondere kann durch das erfindungsgemäße Verfahren die mechanische Festigkeit aus Silicium, Germanium, Galliumarsenid und Cadmiumtellurid bestehende metallische Substrate erhöht werden. Gleichzeitig kann die anorganische keramische Masse derart zusammengesetzt werden, dass eine gezielte Dotierung eines halbleitenden Substrates mit Atomen bzw. Ionen erfolgt, um z.B. in dem halbleitenden Substrat spezielle pn-Übergänge z.B. als Diodenstrukturen wie Schutzdioden auszubilden.

Somit kann parallel zur Erhöhung der Bruchfestigkeit eine gezielte Dotierung des Substrats erfolgen, um gewünschte elektrische Eigenschaften zu erreichen. Daher ist auch bevorzugtes Anwendungsgebiet der erfindungsgemäßen Lehre der Bereich der Solarzellen, wobei Substrate in Form von dünnen Scheiben aus Silicium, Galliumarsenid, Germanium, Cadmiumtellurid oder anderen für die Photo-Voltaik verwendeten Halbleitern der Gruppe IV des Periodensystems bzw. Kombinationshalbleitern aus den Gruppen III und V bzw. II und VI verwendet werden.

Dabei kann die die mechanische Verstärkung bildende anorganische keramische Masse gezielt im Prozessfluss beginnend mit der unprozessierten Halbleiterscheibe bis zur fertigen Solarzelle aufgebracht werden. Durch die aufgebrachte anorganische keramische Masse weist die fertig prozessierte Zelle eine größere Stabilität bei Weiterverarbeitungsschritten bis hin zum Modul auf.

Die anorganische keramische Masse selbst kann z.B. mittels Siebdruck, Tampondruck, Rakeln oder durch Spritzen aufgebracht werden. Auch besteht die Möglichkeit, die anorganische keramische Masse mittels Auflegen und Andrücken auf das metallische Substrat aufzubringen.

Nach einer Weiterbildung der Erfindung ist vorgesehen, dass das Substrat nur bereichsweise mit der anorganischen keramischen Masse versehen wird. So kann die keramische Masse das Substrat rahmenartig umgeben. Auch die Ausbildung einer Gitterstruktur oder Aussparungen in einer ansonsten flächigen Auftragung können vorgesehen sein.

Unabhängig hiervon sollte die anorganische keramische Masse eine Dicke D mit 10 µm ≤ D 500 µm, insbesondere 100 µm ≤ D ≤ 300 µm aufweisen. Diese Dicke bezieht sich auf die ausgehärtete Masse.

Ferner sollte die Zusammensetzung der anorganischen keramischen Masse derart gewählt werden, dass der Ausdehnungskoeffizient der ausgehärteten Masse nahezu der Größenordnung des Substrates entspricht.

Nach einer Ausgestaltung der Erfindung wird vorgeschlagen, dass die anorganische keramische Masse in ein Gewebe oder in Fasern eingearbeitet wird. Als Gewebe kommt ein solches aus SiO₂, SiC- oder C-Fasern in Frage. Auch können Metalldrähte oder Silikatfasern benutzt werden, die das anorganische keramische Material aufweisen. Als organische Fasern, die verwendet werden können, sind Polyethylen, Polyurethan oder Textilfasern zu nennen.

Als bevorzugte anorganische keramische Massen können Siliciumdioxid, Aluminium, Aluminiumoxid, Aluminiumdiborid, Magnesiumoxid, Siliciumnitrid, Lithiumborid, Natriumoxid, Lithiumoxid, Ceroxid, Yttriumoxid, Titandioxid, Boroxid, Bornitrid, Siliciumcarbid, metallurgisches Silicium oder Graphit oder Mischungen dieser verwendet werden, wobei Einzelkomponenten bzw. Mischungen dieser mit einem organischen Bindemittel und insbesondere einem Sinterhilfsmittel versetzt sein können.

Die anorganische keramische Masse kann dabei eine pastenförmige Konsistenz aufweisen oder eine Dispersion sein.

Der Wärmebehandlungsschritt von anorganischer keramischer Masse und dem Substrat, bei dem es sich auch um ein bereits Prozessschritten unterzogenes Substrat handeln kann, ist derart durchzuführen, dass ein Sintern erfolgt. Hierzu wird das Substrat mit der anorganischen keramischen Masse einer Temperatur T₁ mit insbesondere 600 °C ≤ T₁ ≤ 1.650 °C, vorzugsweise 750 °C ≤ T₁ ≤ 950 °C ausgesetzt, bis die anorganische keramische Masse ausgehärtet und gesintert ist. Vorzugsweise erfolgt jedoch zuvor zum Austreiben von Feuchtigkeit oder Lösungsmittel eine Temperaturvorbehandlung bei einer Temperatur T₂ mit 50 °C ≤ T₂ ≤ 500 °C, vorzugsweise 100 °C ≤ T₂ ≤ 300 °C, wobei bei diesem Verfahrensschritt eine oxidierende und/oder inerte Atmosphäre herrschen kann. Durch diesen Vorbehandlungsschritt wird insbesondere eine Rissbildung beim Sinterprozess vermieden.

In besonderen Fällen kann das lokale Aufheizen von Bereichen mit keramischer Paste erforderlich sein. Dabei ist ein lokales Aufheizen der Paste mittels Laser möglich, so dass nicht die gesamte Scheibe mit Wärme beaufschlagt wird. Der Laserstrahl wird über die zu beheizenden Stellen der Probe gerastert. Dabei sintert das keramische Material unter der Hitzeeinwirkung des Lasers.

Ein lokales Aufheizen der Paste kann auch mit einer fokussierten Lichtquelle als Punktlichtquelle oder als linienförmige Lichtquelle erfolgen insbesondere dann, wenn der Randbereich wärmebehandelt werden soll. Der Lampenfokus wird über die zu beheizenden Stellen der Probe positioniert.

Die Sinterttemperatur beträgt grundsätzlich 600 °C bis 1350°C, kurzzeitig bis 1650°C. Da bei Temperaturen oberhalb des Schmelzpunktes von Si (1410 °C) die Oberfläche der Si-Scheibe angeschmolzen wird, ist ein entsprechender Prozessschritt in sehr kurzer Zeit durchzuführen, so dass eine Silicium-Scheibe nicht komplett aufschmelzen kann.

Das Substrat selbst kann eine Dicke zwischen 5 µm und 500 µm, insbesondere zwischen 50 µm und 330 µm aufweisen, ohne dass hierdurch eine Einschränkung der erfindungsgemäßen Lehre erfolgen soll.

Insbesondere wird die anorganische keramische Masse auf der Rückseite eines Substrats einer Solarzelle aufgebracht.

Unabhängig hiervon sollte bevorzugterweise als Substrat mono- und/oder multikristallines Silicium verwendet werden. Nach einem weiteren Vorschlag sollte das Substrat eine Solarzelle aus multikristallinem Silicium, die nach dem EFG-Verfahren hergestellt ist, oder eine photoaktive Schicht dieser sein.

Durch die erfindungsgemäße Lehre ist des Weiteren die Möglichkeit gegeben, dass in Abhängigkeit von der Zusammensetzung der anorganischen keramischen Masse beim Wärmeprozess eine Dotierung des Substrates erfolgt. Dabei können gezielt Schichten gewünschter Leitfähigkeit ausgebildet werden, insbesondere pn-Übergänge, die z.B. als Schutzdioden verschaltet werden.

Nach einem selbständigen Lösungsvorschlag bezieht sich die Erfindung auf eine Solarzelle umfassend photovoltaische Schichten, die sich dadurch auszeichnen, dass auf rückseitiger photovoltaischer Schicht zumindest bereichsweise eine aus anorganischer keramischer Masse bestehende Stabilisierungsschicht angeordnet ist. Dabei kann die anorganische keramische Masse aus Mischungen oder Einzelkomponenten von Siliciumdioxid, Aluminium, Aluminiumoxid, Aluminiumdiborid, Magnesiumoxid, Siliciumnitrid, Lithiumborid, Natriumoxid, Lithiumoxid, Ceroxid, Yttriumoxid, Titandioxid, Boroxid, Bornitirid, Siliciumcarbid, metallurgischem Silicium oder Graphit oder Metallen, die leicht Oxide, Carbide, Nitride oder Boride bilden, bestehen, wobei den Einzelkomponenten bzw. deren Mischung ein organisches Bindemittel und insbesondere ein Sinterhilfsmittel zugegeben ist.

Schließlich bezieht sich die Erfindung auf die Verwendung einer anorganischen keramischen Masse bestehend aus Einzelkomponenten oder einer Mischung von Siliciumdioxid, Aluminium, Aluminiumoxid, Aluminiumdiborid, Magnesiumoxid, Siliciumnitrid, Lithiumborid, Natriumoxid, Lithiumoxid, Ceroxid, Yttriumoxid, Titandioxid, Boroxid, Bornitirid, Siliciumcarbid, metallurgischem Silicium oder Graphit oder Metallen, die leicht Oxide, Carbide, Nitride oder Boride bilden, als Stabilisierungsschicht eines Substrats in Form einer Halbleiterschicht oder eines Schichtsystems aus Silicium, Germanium, Galliumarsenid oder/oder Cadmiumtellurid oder einem oder mehreren Elementen der Gruppe IV des Periodensystems und/oder Kombinationshalbleitern aus den Gruppen III und V bzw. II und VI des Periodensystems, wobei das Schichtsystem eine Dicke dₛ mit 0,5 µm ≤ dₛ ≤ 500 µm aufweist.

Weitere Einzelheiten, Vorteile und Merkmale der Erfindung ergeben sich nicht nur aus den Ansprüchen, den diesen zu entnehmenden Markmalen - für sich und/oder in Kombination -, sondern auch aus der nachfolgenden Beschreibung von der Zeichnung zu entnehmenden bevorzugten Ausführungsbeispielen.

Es zeigen:

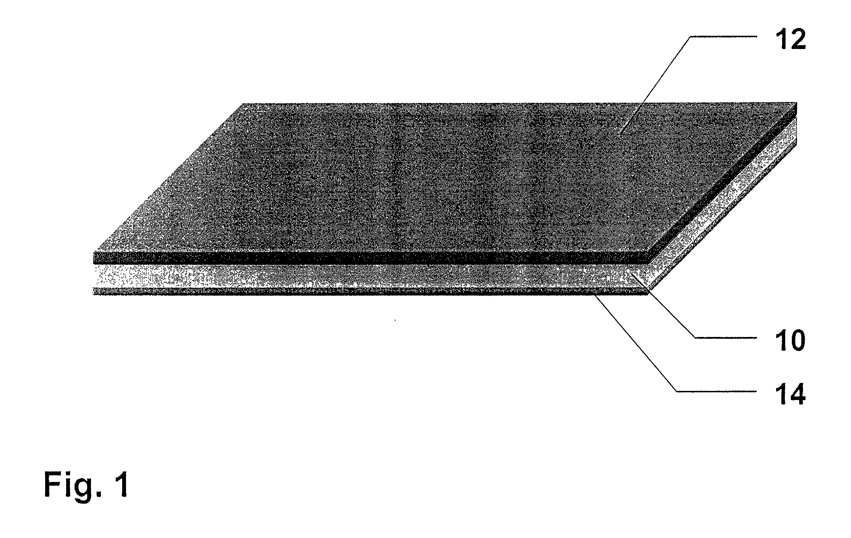

- Fig. 1: eine Prinzipdarstellung einer Solarzelle mit ganzflächig auf der Scheibe aufgebrachter Stabilisierungsschicht,
- Fig. 2: eine weitere Ausführungsform einer Solarzelle mit aufgebrachter Stabilisierungsschicht am Rand der Scheibe,
- Fig. 3: eine dritte Ausführungsform einer Solarzelle mit aufgebrachter Stabilisierungsschicht auf der Rückseite der Scheibe,
- Fig. 4: Solarzelle mit im Randbereich aufgebrachter Stabilisierungsschicht mit Gewebeverstärkung,
- Fig. 5: Solarzelle mit flächig aufgebrachter, gewebeverstärkter Stabilisierungsschicht,
- Fig. 6: ein Gewebe mit auf diesem bereichsweise aufgebrachten anorganischen keramischen Massen, zur Assemblierung und Weiterverarbeitung mehrerer Scheiben.

Um ein flächiges bruchempfindliches Substrat aus insbesondere Halbleitermaterial oder dieses enthaltend zu verstärken, wird auf das Substrat zumindest bereichsweise eine aus anorganischem keramischem Material bestehende Schicht kostengünstigen Materials aufgebracht und mit dem Substrat verbunden. Zur Erläuterung wird die erfindungsgemäße Lehre anhand einer Solarzelle beschrieben, ohne dass hierdurch eine Einschränkung erfolgen soll.

Zur Verstärkung einer Solarzelle, die ebene oder unebene Oberflächen aufweisen kann, wird ganzflächig oder bereichsweise eine anorganische keramische Masse aus Mischungen oder Einzelkomponenten von Siliciumdioxid, Aluminium, Aluminiumoxid, Aluminiumdiborid, Magnesiumoxid, Siliciumnitrid, Lithiumborid, Natriumoxid, Lithiummoxid, Ceroxid, Yttriumoxid, Titandioxid, Boroxid, Bornitrid, Siliciumcarbid, metallurgischem Silicium oder Graphit oder Mischung daraus aufgebracht. Hierdurch ist jedoch eine Einschränkung der verwendeten Materialien nicht gegeben. Vielmehr können auch andere keramische Massen oder Metalle, die keramische Oxide, Carbide, Nitride oder Boride bilden, verwendet werden. Die entsprechenden Materialien werden mit organischen Bindemitteln wie Polymeren und Hilfsstoffen wie Wasser zu Pasten oder Dispersionen und/oder Gelen verarbeitet, wobei auf aus dem Stand der Technik hinlänglich bekannte Verfahren verwiesen wird. Auch kann der Mischung ein Sinterhilfsmittel wie FeO₂, Übergangsmetalloxide wie Yttriumoxid, Magnesiumoxid, Eisenoxid beigegeben werden.

Eine so hergestellte anorganische keramische Masse wird sodann als Schicht 12 auf eine Rückseite einer Halbleiterscheibe 10 aufgebracht, getrocknet und anschließend oder in einem späteren Verfahrensablauf zusammen oder getrennt mit anderweitig notwendigen Temperturbehandlungen während der Herstellung einer Solarzelle gesintert. Im Ausführungsbeispiel soll es sich bei dem Halbleiter um einen p-Halbleiter handeln.

Die als Paste oder Dispersion aufgebrachte Schicht 12 wird durch die entsprechende Temperaturbehandlung ausgehärtet und bildet auf der fertigen Solarzelle eine feste keramische Schicht, die die Halbleiterschicht 10 sowie eine n-Schicht 14 umfasst.

Selbstverständlich besteht auch die Möglichkeit, eine Solarzelle frontseitig, rückseitig oder beidseitig mit einer entsprechenden anorganischen keramischen Massen zur Ausbildung von z.B. einem Rahmen zu versehen.

Durch die feste keramische Schicht 12 wird die fertige Zelle stabilisiert und bei weiteren mechanischen Belastungen, die im Laufe der Prozessierung der Solarzelle auftreten, vor Verformung bzw. Bruch geschützt.

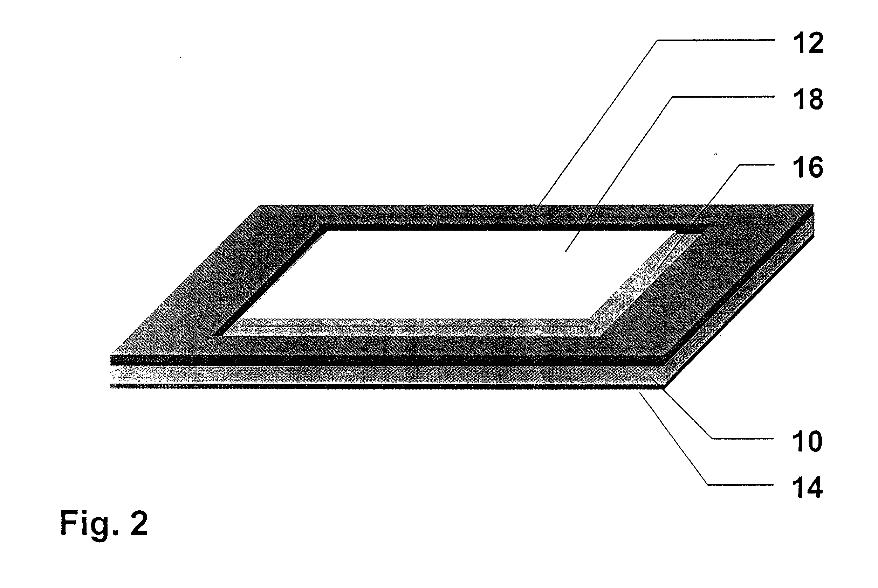

Um eine die Schichten 10 und 14 umfassende Solarzelle rückseitig zu kontaktieren, sind entsprechend dem Ausführungsbeispiel der Fig. 2 in der die Stabilität der Solarzelle erhöhenden Schicht 12 eine oder mehrere Aussparung 16 vorgesehen sind, in die ein oder mehrere metallische Kontakte 18 zum Kontaktieren der Solarzelle anordbar sind.

Durch geeignete Wahl der Dicke der Schicht 12, die örtlich variieren kann, und durch die Verteilung der Schicht auf der Solarzelle bzw. der Aussparung 16 können gewünschte Verstärkungseffekte erzielt werden, so dass auch sehr dünne Halbleiterscheiben eine ausreichende mechanische Stabilität bzw. eine ausreichend stabile Form erreichen.

Das Auftragen der Schicht 12 in Form einer keramischen Paste oder Dispersion kann nach Verfahren erfolgen, wie diese dem Stand der Technik zu entnehmen sind. Beispielhaft sind zu nennen Tampon-Druck, Rollendruck oder Siebdruck. Auch ein Spritzen oder Aufstreichen ist möglich. Bei Letzterem wird dabei vorzugsweise anstelle einer Paste eine Dispersion verwendet.

Sofern die anorganische keramische Masse z. B. Bor oder Aluminium bzw. deren Verbindungen enthält, kann neben der mechanischen Stabilisierung gleichzeitig eine Dotierung in der Schicht - im Ausführungsbeispiel der p-Schicht 10 - erfolgen. Durch geeignete Temperaturbehandlung beim Aushärten bzw. Sintern der Schicht 12 diffundieren entsprechende Atome bzw. Verbindungen in die Halbleiterschicht 10, wodurch eine Ladungsträgerschicht ausgebildet wird, die z.B. als elektrischer Reflektor für negative Minoritätsladungsträger in der Halbleiterschicht 10 wirkt.

Wenn in die keramische Masse Donatorelemente wie z. B. P eingebracht werden, können durch gezieltes lokales Aufbringen der anorganischen keramischen Masse und Aushärten bzw. Sintern dieser pn-Übergänge in die Halbleiterschicht eindiffundiert werden, die eine lokale Diodenstruktur bilden und als Schutzdioden verschaltet werden können.

Die mit der anorganischen keramischen Masse versehenen Substrate wie Siliciumschicht 10 weisen vorzugsweise Dicken von weniger als 300 µm auf.

Die aus dem anorganischen keramischen Material bestehende Schicht 12 sollte nach der Temperaturbehandlung eine Dicke zwischen 120 µm und 300 µm aufweisen.

Zusätzlich kann die Schicht 12 im Bereich des Randes, also deren Kanten eine größere Dicke aufweisen, um einen sogenannten "Schutzrahmen" zu bilden. Im Randbereich kann die Schicht 12 eine Dicke von z. B. 300 bis 350 µm und innerhalb von diesem, also im flächigen Bereich eine Dicke zwischen 180 und 220 µm aufweisen, um nur beispielhaft Zahlen anzugeben.

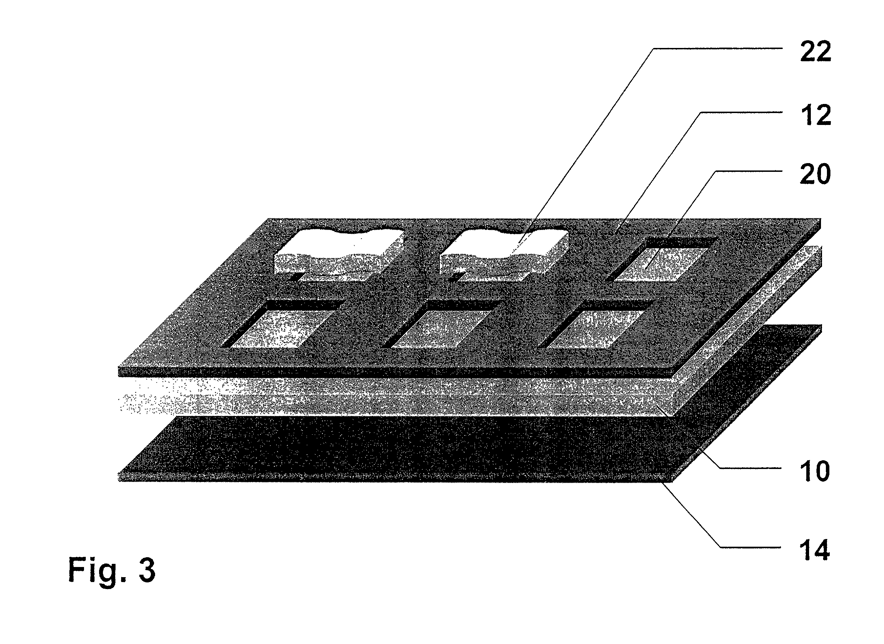

Das Ausführungsbeispiel der Fig. 3 unterscheidet sich von dem der Fig. 2 dahingehend, dass die Schicht 12 mehrere Aussparungen 20 aufweist, in die elektrisch leitende Kontakte 22 eingebracht werden, um eine Rückseitenkontaktierung der Solarzelle zu ermöglichen. Ansonsten weist die in Explosionsdarstellung wiedergegebene Solarzelle einen gleichen Aufbau auf, also im Ausführungsbeispiel die p-Schicht 10, die n-Schicht 14 sowie auf der Rückseite der p-Schicht 10 aufgebrachten anorganischen keramischen durch Temperaturbehandlung gesinterte Teilschicht 12.

Verfahrensmäßig kann die auf der Rückseite der Schicht 10 aufgebrachte anorganische keramische Schicht 12 zunächst als Paste aufgebracht werden, um die anschließend so gebildete Einheit bei einer Temperatur im Bereich zwischen 50 °C und 250 °C zu trocknen. Anschließend erfolgt der eigentliche Sinterprozess bei höherer Temperatur, die im Bereich zwischen 750 °C und 950 °C liegen kann. In Abhängigkeit von der Zusammensetzung der anorganischen keramischen Masse und deren Dicke kann die Temperaturbehandlung im Bereich zwischen 750 °C und 950 °C über einen Zeitraum von 10 bis 60 Minuten erfolgen. In dieser Zeit sintert die anorganische keramische Masse zu einer kompakten Schicht zusammen, die die gewünschte Stabilität erfährt. Gleichzeitig kann erwähntermaßen eine Dotierung der Schicht 10 durch die Diffusion von z.B. Bor oder Aluminium oder deren Verbindungen aus der Schicht 12 in die Halbleiterschicht 10 erfolgen.

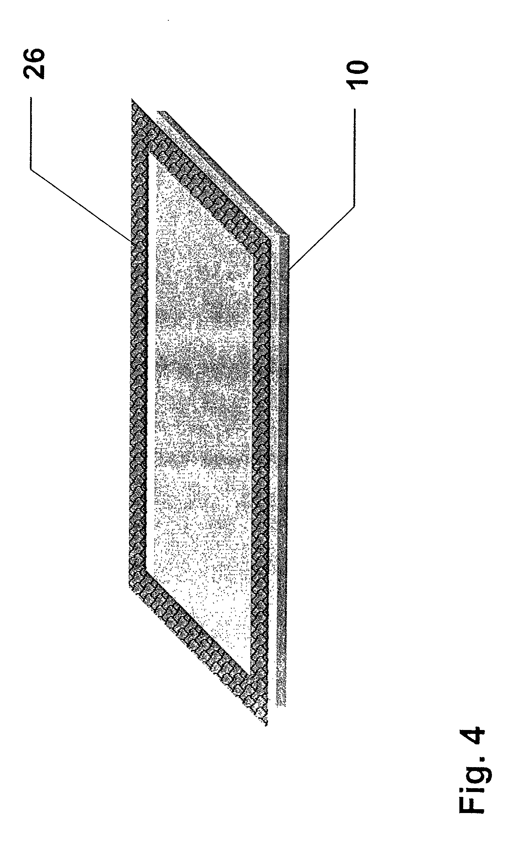

Bei dem Ausführungsbeispiel der Fig. 4 wird zur Stabilisierung der Halbleiterschicht 10 in deren Randbereich ein Gewebeband 24 aufgelegt, das eine anorganische keramische Masse zuvor wiedergegebener Zusammensetzung enthält, also insbesondere eine Mischung oder Einzelkomponenten von Siliciumdioxid, Aluminium, Aluminiumoxid, Aluminiumdiborid, Magnesiumoxid, Siliciumnitrid, Lithiumborid, Natriumoxid, Lithiumoxid, Ceroxid, Yttriumoxid, Titandioxid, Boroxid, Bornitirid, Siliciumcarbid, metallurgischem Silicium oder Graphit sowie organischem Bindemittel und Hilfsstoffen wie Wasser sowie insbesondere einem Sinterhilfsmittel.

Das im Randbereich auf die Schicht 10 aufgedrückte und quasi einen Rahmen bildende Gewebeband mit der anorganischen keramischen Masse wird sodann in einem Vorbehandlungsschritt bei einer Temperatur im Bereich von vorzugsweise 50 °C bis 250 °C getrocknet, wodurch das Gewebeband 24 auf den Rand der Schicht 10 geklebt wird. Anschließend erfolgt eine weitere Temperaturbehandlung bei höherer Temperatur, vorzugsweise im Bereich zwischen 750 °C und 950 °C über einen Zeitraum zwischen 10 und 60 Minuten an Luft. Dabei sintert die anorganische keramische Masse in Abhängigkeit von der Temperatur zu einer kompakten Schicht zusammen, die der Schicht 10 und damit der herzustellenden Zelle eine gewünschte Stabilität verleiht. Das Gewebe 24 verstärkt die keramische Struktur. Gleichzeitig wird die anorganische keramische Masse schonend auf die Scheibe 10 aufgebracht. Nach der Temperaturbehandlung an Luft ist auch eine Behandlung in reaktiver Stickstoffatmosphäre möglich, in der metallische Siliziumanteile zu Si₃N₄ nitridiert werden (Reaktionsnitridierung).

Auch besteht die Möglichkeit, eine Temperaturbehandlung in einer inerten Atmosphäre durchzurühren, in der organische Gewebeanteile zu Kohlenstofffasern pyrolisiert werden, die im weiteren Verlauf der Temperaturbehandlung z.B. zu SiC reagieren können.

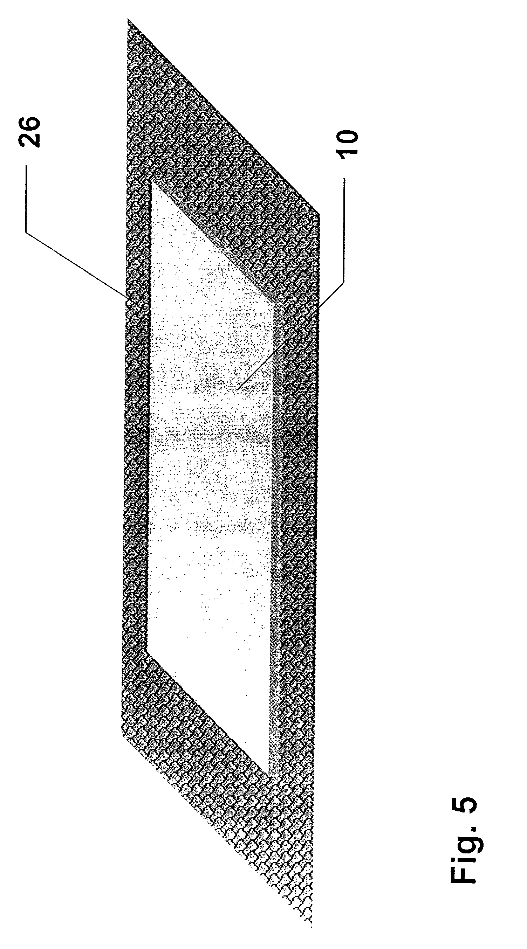

Nach dem Ausführungsbeispiel der Fig. 5 wird ein flächiges Gewebe 26 mit einer die anorganische keramische Masse einschließlich organische Klebekomponente sowie insbesondere Sinterhilfmittel enthaltenden Paste flächig auf die Rückseite der Scheibe bzw. Schicht 10 aufgelegt bzw. deren Rändern zusätzlich eingefaßt. Es schließt sich ein Vorbehandlungsschritt im Temperaturbereich zwischen 50 °C und 150 °C zum Trocknen der Paste und Klebung des Gewebes an. Danach wird die so behandelte Einheit einer weiteren Temperaturbehandlung bei höherer Temperatur, vorzugsweise im Bereich zwischen 750 °C und 950 °C über eine Dauer von 10 bis 60 Minuten an Luft, Stickstoff oder inerter Atmosphäre unterzogen. Dabei sintert die anorganische keramische Masse in Abhängigkeit von der Temperatur zu einer kompakten Schicht zusammen, die der Schicht 10 und damit der herzustellenden Zelle gewünschte Stabilität verleiht. Die Paste ist in Fig. 5 grau schattiert angedeutet.

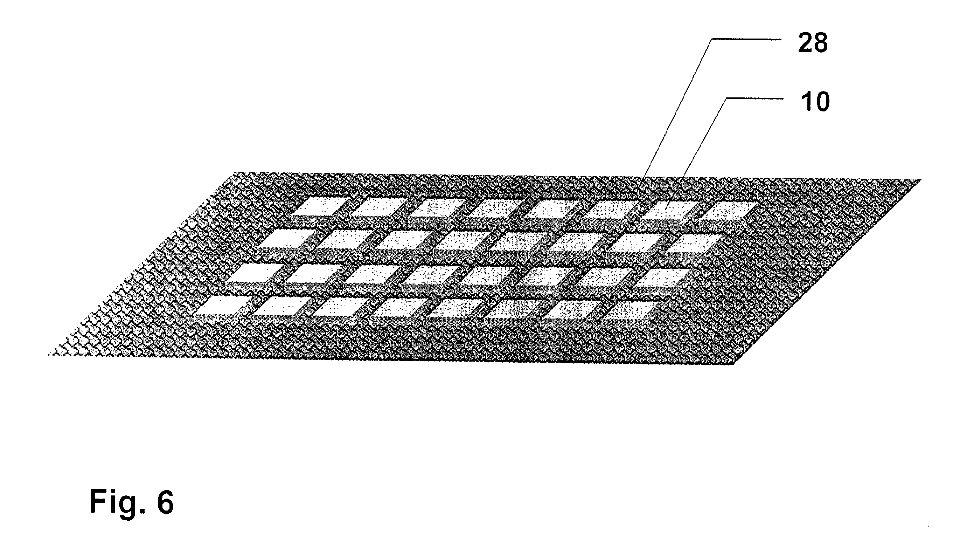

Bei dem Ausführungsbeispiel der Fig. 6 wird ein großflächiges Gewebe 28 mit einer Paste unterlegt, die aus den zuvor erläuterte Materialien besteht, also vereinfacht ausgedrückt aus einem keramischen Füller und organischer Klebekomponente. Die Paste ist in Fig. 6 grau schattiert angedeutet.

Auf die Paste-Gewebeeinheit können mehrere Scheiben entsprechend der Scheibe 10 aufgelegt werden. Mit weiteren Geweben wie Bändern können die Ränder der Scheiben zusätzlich eingefaßt werden. Sodann erfolgt in einem Vorbehandlungsschritt die Trocknung der Paste sowie eine Klebung des Gewebes. Dieser Vorbehandlungsschritt wird vorzugsweise im Temperaturbereich zwischen 50 °C und 150 °C durchgeführt. Anschließend wird eine so behandelte Zellenanordnung einer weiteren Temperaturbehandlung unterzogen, und zwar im Bereich zwischen vorzugsweise 750 °C und 950 °C über einen Zeitraum zwischen 10 und 60 Minuten. Die Temperaturbehandlung kann dabei an Luft oder in Stickstoff oder inerter Atmosphäre erfolgen. Bei der entsprechenden Temperatur sintert die keramische Masse zu einer kompakten Schicht, durch die den Zellen die gewünschte Stabilität verliehen wird.

Das Ausführungsbeispiel der Fig. 6 ermöglicht ein gleichzeitiges Prozessieren mehrerer Scheiben z. B. am Laufband. Ein so assembliertes Produkt kann als Grundform für eine anschließende Modulfertigung zur Erleichterung der Fertigungsschritte beitragen.

## Patentansprüche

1. Verfahren zum Ausbilden einer Schichtstruktur auf einem insbesondere bruchempfindlichen flächigen Substrat
**gekennzeichnet durch**
die Verfahrensschritte
- zumindest bereichsweises Aufbringen einer anorganischen keramischen Masse auf das bruchempfindliche Substrat und
- anschließende Wärmebehandlung zum Aushärten und Sintern der anorganischen keramischen Masse.

2. Verfahren nach Anspruch 1,
**dadurch gekennzeichnet,**
**dass** die anorganische keramische Masse mittels Siebdruck, Tampondruck, Rakeln und/oder durch Spritzen aufgebracht oder zumindest bereichsweise auf das Substrat aufgelegt und sodann auf dieses aufgedrückt wird.

3. Verfahren nach Anspruch 1 oder 2,
**dadurch gekennzeichnet,**
**dass** die anorganische keramische Masse zur Bildung eines Rahmens im Randbereich des Substrats zumindest abschnittsweise aufgebracht wird und/oder dass die anorganische keramische Masse auf das Substrat derart aufgebracht wird, dass sich eine Gitterstruktur ergibt und/oder dass die anorganische keramische Masse zur Bildung von Freiräumen auf das Substrat bereichsweise aufgebracht wird.

4. Verfahren nach zumindest einem der vorhergehenden Ansprüche,
**dadurch gekennzeichnet,**
**dass** die anorganische keramische Masse mit einer Dicke d mit insbesondere 10 µₘ ≤ d ≤ 500 µm, vorzugsweise 100 µm ≤ d ≤ 300 µm auf das Substrat aufgebracht wird.

5. Verfahren nach zumindest einem der vorhergehenden Ansprüche,
**dadurch gekennzeichnet,**
**dass** die anorganische keramische Masse in einem Gewebe, in einem Metalldraht oder in Fasern eingearbeitet und auf das Substrat aufgebracht wird, wobei vorzugsweise als Gewebe ein solches aus SiO₂-, SiC- und/oder C-Fasern, insbesondere silicatischen Fasern, bestehendes oder diese enthaltendes Gewebe verwendet wird.

6. Verfahren nach zumindest einem der vorhergehenden Ansprüche,
**dadurch gekennzeichnet,**
**dass** als Fasern organische Fasern wie Polyethylen- oder Polyurethanfasern oder Textilfasern eingearbeitet werden.

7. Verfahren nach zumindest einem der vorhergehenden Ansprüche,
**dadurch gekennzeichnet,**
**dass** als anorganische keramische Masse eine solche verwendet wird, deren Ausdehnungskoeffizient im gesinterten Zustand dem des Substrats entspricht.

8. Verfahren nach zumindest einem der vorhergehenden Ansprüche,
**dadurch gekennzeichnet,**
**dass** das mit der anorganischen keramischen Masse versehene Substrat einer Wärmebehandlung bei einer Temperatur T₁ mit insbesondere 600 °C ≤ T₁ ≤ 1.650 °C, vorzugsweise 750 °C ≤ T₁ ≤ 950 °C ausgesetzt wird, wobei gegebenenfalls das mit der anorganischen keramischen Masse versehene Substrat in einer Wärmevorbehandlungsstufe einer Temperatur T₂ mit insbesondere 50 °C ≤ T₂ ≤ 500 °C, vorzugsweise 100 °C ≤ T₂ ≤ 300 °C ausgesetzt wird.

9. Verfahren nach zumindest einem der vorhergehenden Ansprüche,
**dadurch gekennzeichnet,**
**dass** das mit der anorganischen keramischen Substanz versehene Substrat der Temperatur T₁ über einen Zeitraum t mit 5 min ≤ t ≤ 100 min, vorzugsweise 10 min ≤ t ≤ 60 min und/oder dass das mit der anorganischen keramischen Masse versehene Substrat einer Temperatur 1200 °C ≤ T3 ≤ 1650°C über einen Zeitraum t mit 5 µs ≤ t ≤ 10 min, vorzugsweise 10 µs ≤ t ≤ 60 s, ausgesetzt wird.

10. Verfahren nach zumindest einem der vorhergehenden Ansprüche,
**dadurch gekennzeichnet,**
**dass** das mit der anorganischen keramischen Masse versehene Substrat bei einer Temperatur T3 mit 600 °C ≤ T3 ≤ 1650 °C, insbesondere 750 °C ≤ T3 ≤ 950 °C, lokal erhitzt wird, insbesondere durch einen Laserstrahl und/oder durch Einwirkung eines fokussierten Lichtstrahls lokal erhitzt wird.

11. Verfahren nach zumindest einem der vorhergehenden Ansprüche,
**dadurch gekennzeichnet,**
**dass** als anorganische keramische Masse Siliciumdioxid, Aluminium, Aluminiumoxid, Aluminiumdiborid, Magnesiumoxid, Siliciumnitrid, Lithiumborid, Natriumoxid, Lithiumoxid, Ceroxid, Yttriumoxid, Titandioxid, Boroxid, Bornitirid, Siliciumcarbid, metallurgisches Silicium, Graphit oder keramische Oxide, Karbide, Nitride oder Boride bildende Metalle als Einzelkomponenten oder Mischungen dieser verwendet werden, die mit einem Bindemittel und gegebenenfalls einem Sinterhilfsmittel versetzt werden, und/oder dass als anorganische keramische Masse eine pastenförmige Masse verwendet wird und/oder dass als anorganische keramische Masse eine Dispersion und/oder ein Gel verwendet wird.

12. Verfahren nach zumindest einem der vorhergehenden Ansprüche,
**dadurch gekennzeichnet,**
**dass** als Substrat ein solches aus Silicium, Galliumarsenid, Cadmiumtellurid, Germanium oder einem Halbleiter der Gruppe IV des Periodensystems oder einem Kombinationshalbleiter aus den Gruppen III und V und/oder II und VI bestehend und/oder sowie deren ternären Erweiterungen verwendet wird.

13. Verfahren nach zumindest einem der vorhergehenden Ansprüche,
**dadurch gekennzeichnet,**
**dass** als Substrat eine Halbleiterscheibe, vorzugsweise eine zumindest teilweise prozessierte Solarzelle verwendet wird.

14. Verfahren nach zumindest einem der vorhergehenden Ansprüche,
**dadurch gekennzeichnet,**
**dass** die anorganische keramische Masse auf der Rückseite einer photovoltaisch aktiven Schicht einer Solarzelle aufgebracht wird.

15. Verfahren nach zumindest einem der vorhergehenden Ansprüche,
**dadurch gekennzeichnet,**
**dass** als Substrat ein solches aus mono- und/oder multikristallinem Silicium bestehend verwendet wird.

16. Verfahren nach zumindest einem der vorhergehenden Ansprüche,
**dadurch gekennzeichnet,**
**dass** die anorganische keramische Masse als Verstärkung auf Vorder- und/oder Rückseite einer Solarzelle, insbesondere aus mono- und/oder multikristallinem Silicium bestehend aufgebracht wird.

17. Verfahren nach zumindest einem der vorhergehenden Ansprüche,
**dadurch gekennzeichnet,**
**dass** als Substrat eine Solarzelle aus multikristallinem Silicium verwendet wird, die nach dem EFG- (Edge-defined Film-fed Growth) Verfahren hergestellt wird.

18. Verfahren nach zumindest einem der vorhergehenden Ansprüche,
**dadurch gekennzeichnet,**
**dass** das Substrat in Form von zumindest einer Solarzellenschicht mit auf dieser aufgebrachten anorganischen keramischen Masse derart wärmebehandelt wird, dass das Substrat im gewünschten Umfang dotiert wird, wobei gegebenenfalls eine lokale Dotierung im Rückseiten- und/oder Vorderseiten- und/oder Randbereich des Substrats durchgeführt wird.

19. Verfahren nach zumindest einem der vorhergehenden Ansprüche,
**dadurch gekennzeichnet,**
**dass** die Solarzellenschicht derart dotiert wird, dass sich ein pn-Übergang in dem Substrat ausbildet, der vorzugsweise als Schutzdiode verschaltet wird.

20. Solarzelle umfassend photoaktive Schichten,
**dadurch gekennzeichnet,**
**dass** auf rückseitiger photoaktiver Schicht zumindest bereichsweise eine aus anorganischer keramischer Masse bestehende Stabilisierungsschicht angeordnet ist.

21. Solarzelle nach Anspruch 20,
**dadurch gekennzeichnet,**
**dass** die anorganische keramische Masse aus Siliciumdioxid, Aluminium, Aluminiumoxid, Aluminiumdiborid, Magnesiumoxid, Siliciumnitrid, Lithiumborid, Natriumoxid, Lithiumoxid, Ceroxid, Yttriumoxid, Titandioxid, Boroxid, Bornitirid, Siliciumcarbid, metallurgisches Silicium, Graphit oder keramische Oxide, Karbide, Nitride oder Boride bildende Metalle besteht oder diese enthält.

22. Verwendung einer anorganischen keramischen Masse aus Siliciumdioxid, Aluminium, Aluminiumoxid, Aluminiumdiborid, Magnesiumoxid, Siliciumnitrid, Lithiumborid, Natriumoxid, Lithiumoxid, Ceroxid, Yttriumoxid, Titandioxid, Boroxid, Bornitirid, Siliciumcarbid, metallurgisches Silicium, Graphit, keramischen Oxiden, Karbiden, Nitriden oder Boriden bildenden Metallen als Stabilisierungsschicht für ein flächiges Substrat in Form einer Halbleiterscheibe oder insbesondere aus Silicium, Galliumarsenid, Cadmiumtellurid, Germanium oder einem Halbleiter der Gruppe IV des Periodensystems oder einem Kombinationshalbleiter aus den Gruppen III und V und/oder II und VI bestehendes oder diese enthaltendes Schichtsystem mit einer Dicke im Bereich zwischen 0,5 µm und 500 µm.
